(19) Europäisches Patentamt
European Patent Office
Office européen des brevets

(11) **EP 3 753 117 B1**

(12) **FASCICULE DE BREVET EUROPEEN**

(45) Date de publication et mention
de la délivrance du brevet:
**16.03.2022 Bulletin 2022/11**

(21) Numéro de dépôt: **19700618.2**

(22) Date de dépôt: **18.01.2019**

(51) Classification Internationale des Brevets (IPC):
**H04B 3/54** *(2006.01)*　　**G01R 29/18** *(2006.01)*
**H02J 3/26** *(2006.01)*　　**H02J 13/00** *(2006.01)*
**G01R 19/25** *(2006.01)*

(52) Classification Coopérative des Brevets (CPC):
**H04B 3/54; G01R 29/18; H02J 3/26;**
**H02J 13/00007;** G01R 19/2513; H04B 2203/5466;
Y02E 40/50; Y02E 60/00; Y02E 60/7815;
Y04S 40/121

(86) Numéro de dépôt international:
**PCT/EP2019/051274**

(87) Numéro de publication internationale:
**WO 2019/158310 (22.08.2019 Gazette 2019/34)**

(54) **DETERMINATION DE LA PHASE D'UN CONDUCTEUR APPARTENANT A UN RESEAU POLYPHASE**

BESTIMMUNG DER PHASE EINES ZU EINEM MEHRPHASIGEN NETZWERK GEHÖRENDEN LEITERS

DETERMINING THE PHASE OF A CONDUCTOR BELONGING TO A POLYPHASE NETWORK

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.02.2018　FR 1851333**

(43) Date de publication de la demande:
**23.12.2020　Bulletin 2020/52**

(73) Titulaire: **Enedis**
**92079 Paris La Defense Cedex (FR)**

(72) Inventeurs:
• **ACHAICHIA, Pierre**
**44000 Nantes (FR)**
• **CHAUVENET, Cédric**
**92310 Sevres (FR)**

(74) Mandataire: **Plasseraud IP**
**66, rue de la Chaussée d'Antin**
**75440 Paris Cedex 09 (FR)**

(56) Documents cités:
EP-A1- 2 685 267　　　WO-A1-2005/116668
US-A1- 2015 091 545

**Description**

La présente invention concerne la détermination de la phase d'un conducteur électrique qui appartient à un réseau polyphasé de distribution de courant électrique.

Dans un réseau polyphasé de distribution de courant électrique, notamment un réseau triphasé, il est utile de connaître la phase d'un conducteur électrique de ce réseau, lorsque c'est un conducteur de phase, notamment pour équilibrer entre les différentes phases du réseau la puissance électrique qui est fournie par le réseau.

Des méthodes existent pour comparer entre elles les phases de plusieurs conducteurs du réseau, notamment à l'aide d'appareils portatifs qui déterminent l'ordre des phases des conducteurs qui sont testés. Mais ces méthodes requièrent l'installation de deux appareils pour déterminer les phases des conducteurs à un endroit du réseau par rapport à une phase de référence qui est définie à un autre endroit du réseau, éloigné de l'endroit où les phases sont testées. En effet, un premier appareil portatif doit être installé pour cela à l'endroit du réseau où les phases sont testées, alors qu'un second appareil portatif est installé à l'autre endroit du réseau sur le conducteur qui détermine la phase de référence.

Par ailleurs, les technologies CPL, pour «courant porteur en ligne», conformément aux normes correspondantes, permettent de transmettre des données en utilisant comme support de transmission les conducteurs de distribution du courant électrique. Pour cela, des unités de production de données à transmettre, et aussi auxquelles des données peuvent être destinées, sont connectées à divers endroits du réseau de distribution de courant électrique par l'intermédiaire de modems dédiés. De telles unités peuvent être notamment des compteurs de consommation électrique, qui sont alors dits compteurs communicants, tels que les compteurs Linky® actuellement déployés par ENEDIS®.

La norme CPL G3 permet des communications par transmission de trames qui sont dites asynchrones. En effet, dans le protocole CPL G3, les trames sont émises à des instants qui correspondent à des valeurs variables de la phase instantanée de la tension électrique du conducteur du réseau à partir duquel la trame est émise. Mais la norme CPL G3 prévoit que les trames contiennent chacune une indication de la valeur instantanée de la phase de la tension électrique du conducteur à partir duquel la trame est émise, telle que cette valeur instantanée de phase existe à l'instant auquel cette trame est émise. Une durée de traitement de la trame à l'émission peut être négligée, ou peut être prise en compte dans une correction qui sera appliquée lors de la réception de la trame. Cette indication de valeur instantanée de la phase de la tension électrique est produite par le modem émetteur de la trame au moyen d'un compteur de phase à 8 bits, qui est incrémenté à la fréquence du réseau multipliée par 256. Ainsi, un cycle de comptage est parcouru pendant chaque période de la tension électrique, et un nouveau passage du compteur de phase par la valeur nulle est effectué chaque fois que la tension électrique du conducteur passe par zéro sur un front montant. Selon la norme CPL G3, la valeur de ce compteur de phase à l'instant d'émission d'une trame est systématiquement inscrite dans le champ PDC de l'en-tête de cette trame. Elle est donc lisible par un autre modem du réseau qui reçoit cette trame.

Par ailleurs, la norme CPL G3 prévoit que chaque modem qui est raccordé au réseau construise une table dite «table des voisins». Pour cela, lorsqu'il est nouvellement associé au réseau, un modem émet une requête d'émission de balise, aussi désignée par requête de balise. D'autres modems, qui sont aussi connectés au réseau et qui reçoivent cette requête de balise, y répondent en émettant chacun une trame de balise sur le réseau. Le modem émetteur de la requête collecte alors les trames de balises, et enregistre pour chacune d'elles une adresse du modem émetteur de cette trame de balise, et l'indication de valeur instantanée de phase qui est contenue dans le champ PDC de la trame de balise. Il compare alors cette indication de valeur instantanée de phase qui est lue, et qui concerne le conducteur auquel est connecté le modem émetteur de la trame de balise, avec la valeur instantanée de son propre compteur de phase. A partir d'une différence entre la valeur de phase qui est lue dans la trame de balise et celle qui est fournie par son propre compteur de phase, le modem récepteur de la trame de balise obtient la valeur du déphasage qui existe entre la tension électrique du conducteur du modem émetteur de la trame de balise et celle du conducteur auquel il - le modem récepteur de la trame de balise qui est aussi l'émetteur de la requête de balise - est lui-même connecté. La durée de propagation de la trame de balise dans le réseau entre les deux modems est négligeable. Eventuellement, le déphasage qui est ainsi calculé peut être corrigé d'une durée de traitement de la trame de balise dans les deux modems. Les modems qui ont répondu à la requête de balise sont ceux qui, dans le réseau, ne sont pas trop éloignés du modem émetteur de cette requête pour avoir reçu cette dernière dans des conditions satisfaisantes, et qu'ensuite la trame de balise qui est émise par chacun d'eux soit reçue aussi dans des conditions satisfaisantes par le modem émetteur de la requête. Les modems qui ont participé à un tel échange de communication sont usuellement qualifiés de «voisins» du modem émetteur de la requête. Ce dernier mémorise alors dans sa table des voisins, l'adresse de chaque modem voisin en correspondance avec la valeur du déphasage qui existe entre les conducteurs respectifs du réseau auxquels sont connectés ce modem voisin et le modem qui héberge la table.

Une telle utilisation des trames de balises est mise en œuvre pendant la phase d'association d'un modem au réseau CPL. Une fois que chaque modem est associé au réseau CPL, les modems transmettent entre eux des trames de types autres que les trames de balises, mais ces autres trames ont chacune aussi un champ PDC dans lequel le modem émetteur de la trame inscrit la valeur de son compteur de phase telle qu'existant à l'instant d'émission de la trame.

Toutefois, la norme CPL G3 ne prévoit pas d'identifier la phase d'un conducteur du réseau par rapport à une phase de référence qui serait commune à tout le réseau, ou commune à au moins une partie du réseau comprenant plusieurs modems qui ne sont pas tous voisins entre eux au sens indiqué ci-dessus. Autrement dit, les tables de voisins qui sont mémorisées dans chaque modem utilisent chacune comme référence de phase la phase du conducteur du réseau auquel ce modem est connecté, et non pas une phase de référence commune. Des exemples de procédés et dispositifs de l'art antérieur sont divulgués dans la demande PCT WO 2005/116668 A1, dans la demande de brevet européen EP 2685267 A1, ainsi que dans la demande de brevet américain US 2015/0091545 A1.

La présente invention a alors pour but de déterminer la phase d'un conducteur de phase d'un réseau polyphasé, par rapport à une phase de référence qui est commune à tout le réseau, ou à une grande partie de celui-ci. Notamment, l'invention vise à déterminer la phase d'un conducteur de phase du réseau, même lorsque des trames CPL ne peuvent pas être transmises directement entre ce conducteur de phase et un autre qui détermine la phase de référence.

En outre, un but complémentaire de l'invention est de déterminer la phase d'un conducteur de phase du réseau avec un niveau de fiabilité suffisant.

En particulier, l'invention a pour but de déterminer la phase d'un conducteur de phase lorsque le réseau est équipé pour un mode de communication de type CPL asynchrone.

Enfin, un but annexe de l'invention est de déterminer la phase d'un conducteur du réseau d'une façon qui puisse être automatique et renouvelée autant que besoin, notamment lorsque le réseau a été modifié, sans nécessiter qu'un opérateur se déplace jusqu'au conducteur dont la phase est à déterminer.

Pour atteindre l'un au moins de ces buts ou d'autres, un premier aspect de l'invention propose un nouveau procédé pour déterminer la phase d'un conducteur de phase qui appartient à un réseau polyphasé de distribution de courant électrique, notamment un réseau triphasé. Dans ce cadre, un conducteur de phase quelconque du réseau possède une phase qui détermine un déphasage de tension électrique existant entre ce conducteur et un autre conducteur de phase du réseau servant de référence, appelé conducteur de phase de référence.

Pour l'invention, le réseau comporte des modems qui sont connectés chacun à un des conducteurs de phase du réseau, et qui sont adaptés pour communiquer selon un protocole de courant porteur en ligne, ou CPL. Autrement dit, le réseau auquel l'invention est appliquée est du type réseau communicant de distribution de courant électrique.

Le procédé de l'invention comprend alors la séquence des étapes suivantes, exécutée pour un des conducteurs de phase du réseau, dit conducteur cible, qui est identifié et dont la phase est à déterminer :

/1/ construire plusieurs suites de conducteurs de phase du réseau, différentes entre elles et commençant chacune par le conducteur de phase de référence, terminant chacune par le conducteur cible, et contenant chacune une sélection ordonnée d'un ou plusieurs conducteurs de phase du réseau, qui sont intermédiaires entre le conducteur de phase de référence et le conducteur cible dans chaque suite, et pour lesquels un déphasage de tension électrique qui existe entre deux conducteurs qui sont successifs dans une des suites a été obtenu par un modem qui est connecté à l'un de ces deux conducteurs, pour tous les couples de conducteurs successifs de chaque suite ;

/2/ pour chaque suite construite à l'étape /1/, calculer un résultat d'addition comme une somme des déphasages de tous les couples de conducteurs successifs de cette suite ;

/3/ en considérant que les résultats d'addition calculés à l'étape /2/ forment une distribution statistique, et compte tenu d'une congruence entre des valeurs différentes qui représentent un même déphasage, déterminer celui de ces résultats d'addition qui possède une fréquence d'apparition la plus élevée ; et

/4/ déclarer le résultat d'addition qui possède la fréquence d'apparition la plus élevée comme phase du conducteur cible si cette fréquence d'apparition la plus élevée est supérieure ou égale à un seuil de fiabilité prédéfini, sinon déclarer la phase du conducteur cible comme étant indéterminée si la fréquence d'apparition la plus élevée est inférieure au seuil de fiabilité.

Ainsi, selon l'invention, la phase d'un conducteur de phase du réseau est déterminée en additionnant des déphasages qui sont déterminés entre des couples successifs de conducteurs, pour établir le déphasage de tension électrique qui existe entre le conducteur cible et le conducteur de phase de référence. Ce calcul d'addition est répété de façon redondante en utilisant des combinaisons de déphasages qui sont différentes, puis une étude statistique des résultats d'addition fournit un niveau de fiabilité du résultat le plus fréquent. Ce résultat le plus fréquent est alors validé comme phase qui est déterminée pour le conducteur cible si son niveau de fiabilité est suffisant.

Grâce à l'addition des déphasages pour une même suite de conducteurs, le procédé de l'invention ne nécessite pas que le conducteur cible et le conducteur de phase de référence soient en visibilité de communication directe l'un pour l'autre.

En outre, le procédé peut facilement être exécuté de façon automatisée, avec de nouvelles exécutions qui sont déclenchées périodiquement ou lorsqu'une modification du réseau est déclarée.

Préférablement, le seuil de fiabilité qui est utilisé à l'étape /4/ peut être compris entre 0,7 et 0,9, et plus préférablement encore entre 0,75 et 0,85, et le nombre de suites qui sont construites à l'étape /1/ pour chaque conducteur cible peut être compris entre 3 et 15, afin de minimiser une quantité des calculs qui sont nécessaires pour chaque exécution du procédé de l'invention.

Préférablement aussi, les suites qui sont construites à l'étape /1/ pour un même conducteur cible peuvent comprendre au moins une suite qui est la plus courte parmi ces suites, et des suites supplémentaires. Alors, ces dernières peuvent être sélectionnées pour minimiser une augmentation de longueur de chaque suite supplémentaire par rapport à la suite qui est la plus courte, la longueur de chaque suite étant le nombre des conducteurs de cette suite. En effet, le résultat d'addition qui est obtenu pour une suite peut être affecté par une erreur, par rapport à la phase du conducteur cible, et la probabilité d'une telle erreur est d'autant plus grande que la suite est longue. Pour cette raison, minimiser la longueur des suites utilisées participe à augmenter la fiabilité de chaque résultat d'addition en tant que phase possible pour le conducteur cible.

Préférablement encore, pour au moins un des couples de conducteurs successifs d'une des suites, deux valeurs du déphasage de tension électrique qui existe entre les deux conducteurs du couple sont collectées séparément. L'une de ces deux valeurs du déphasage est collectée à partir d'un modem qui est connecté à l'un des deux conducteurs, et l'autre de ces deux valeurs du déphasage est collectée à partir d'un autre modem qui est connecté à l'autre des deux conducteurs. Alors, ce couple de conducteurs successifs n'est utilisé dans l'une des suites qui est construite à l'étape /1/ que si les deux valeurs du déphasage sont opposées. Une telle redondance de collecte du déphasage, avec l'exigence de cohérence entre les deux valeurs qui sont collectées, peut être appliquée à de nombreux couples de conducteurs successifs qui apparaissent dans les suites construites, voire à tous les couples. De cette façon, la fiabilité de la phase qui est déterminée pour le conducteur cible peut être encore améliorée.

Dans diverses mises en œuvre de l'invention, les caractéristiques optionnelles suivantes peuvent en outre être utilisées, indépendamment les unes des autres ou en combinaison de plusieurs d'entre elles :

- un concentrateur du réseau peut être connecté au conducteur de phase de référence. Dans ce cas, le procédé peut être mis en œuvre par ce concentrateur. Chaque déphasage de tension électrique qui existe entre deux conducteurs successifs d'une des suites construites à l'étape /1/ est alors transmis au concentrateur par le modem qui est connecté à l'un des deux conducteurs ;

- le protocole de courant porteur en ligne peut être CPL G3 ;

- chaque déphasage de tension électrique qui existe entre deux conducteurs qui sont successifs dans une des suites peut avoir été obtenu par le modem qui est connecté à l'un de ces deux conducteurs, dit modem récepteur, en recevant une trame qui a été émise par un autre modem connecté à l'autre des deux conducteurs, dit modem émetteur, et en comparant une indication de valeur instantanée de phase de tension électrique qui a été inscrite dans la trame par le modem émetteur à un instant d'émission de cette trame, avec une valeur instantanée d'un compteur de phase du modem récepteur, telle qu'existant à un instant de réception de la trame par le modem récepteur ;

- les phases de plusieurs conducteurs de phase du réseau, telles qu'elles ont été déclarées chacune lors d'une exécution de l'étape /4/, peuvent être utilisées lorsque ces phases sont différentes, pour équilibrer entre ces conducteurs de phase une puissance électrique qui est fournie par le réseau ; et

- le seuil de fiabilité qui est utilisé à l'étape /4/ peut varier en fonction du nombre des suites qui ont été construites à l'étape /1/ pour le conducteur cible. La fiabilité de la phase déterminée peut ainsi être analysée plus finement, notamment afin de ne pas rejeter un résultat correct en appliquant une exigence de fiabilité trop élevée.

Un deuxième aspect de l'invention propose un concentrateur pour réseau polyphasé de distribution de courant électrique, lorsque ce réseau comporte des modems qui sont connectés chacun à un des conducteurs de phase du réseau, et lorsque les modems sont adaptés pour communiquer selon un protocole de courant porteur en ligne, ou CPL. Un tel concentrateur est adapté pour obtenir des déphasages qui existent entre des tensions électriques respectives de conducteurs de phase du réseau qui sont associés en couples de conducteurs, avec une valeur de déphasage pour chaque couple de conducteurs. Alors, le concentrateur comprend un modem dédié, une unité de calcul et des moyens de mémorisation qui sont agencés pour mettre en œuvre un procédé qui est conforme au premier aspect de l'invention.

Enfin, un troisième aspect de l'invention propose un nouveau logiciel pour concentrateur, en tant que produit programme d'ordinateur, et faisant fonction de logiciel unique dans le jargon de l'Homme du métier. Ce logiciel comprend des codes de programmation qui sont adaptés de sorte que lorsque le logiciel est mis en œuvre dans un concentrateur d'un réseau polyphasé de distribution de courant électrique, le réseau comportant des modems connectés chacun à un des conducteurs de phase du réseau, et les modems étant adaptés pour communiquer selon un protocole de courant porteur en ligne, ou CPL, le concentrateur exécute un procédé qui est conforme au premier aspect de l'invention. Un tel logiciel peut être téléchargé à distance dans le concentrateur, puis stocké sur un support de données non volatile de ce concentrateur.

D'autres particularités et avantages de la présente invention apparaîtront dans la description ci-après d'exemples de réalisation non limitatifs, en référence au dessin suivant qui est annexé :

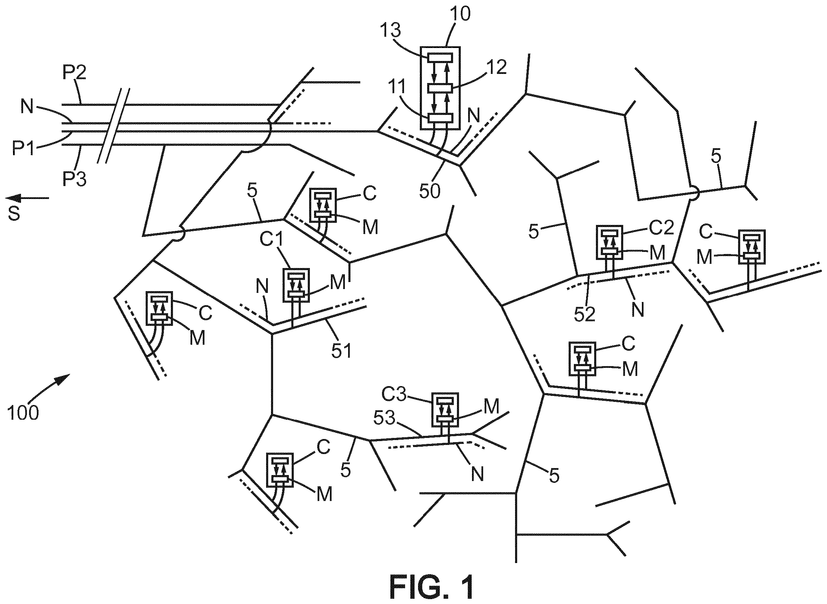

- la figure 1 représente un réseau de distribution de courant électrique auquel l'invention est appliquée.

Pour raison de clarté, les dimensions des éléments qui sont représentés dans cette figure ne correspondent ni à des dimensions réelles ni à des rapports de dimensions réels. En outre, des références identiques qui y sont indiquées désignent des éléments identiques ou qui ont des fonctions identiques.

Un réseau de distribution de courant électrique 100 est par exemple un réseau triphasé. A ce titre, il comprend des conducteurs 5 qui ont chacun l'une des trois phases du réseau, et qui sont appelés conducteurs de phase. Les trois phases du réseau 100 peuvent être désignées par 0°, 120° et 240°. Par exemple, trois conducteurs du réseau, en provenance d'une source S de production de courant électrique, peuvent avoir la phase 0° pour l'un qui est référencé P1, la phase 120° pour un deuxième d'entre eux qui est référencé P2, et la phase 240° pour le troisième qui est référencé P3. Tous les conducteurs 5 du réseau 100 qui sont raccordés au conducteur P1 ont alors la phase 0°, tous ceux qui sont raccordés au conducteur P2 ont la phase 120°, et tous ceux qui sont raccordés au conducteur P3 ont la phase 240°. Le problème technique que résout l'invention est de déterminer laquelle de ces trois phases, 0°, 120° et 240°, est celle d'un conducteur 5 du réseau 100 lorsqu'il n'est pas possible de suivre physiquement la suite des raccordements qui relient ce conducteur 5 à l'un des trois conducteurs P1, P2 et P3.

Evidemment, le réseau 100 est pourvu de conducteurs de neutre N, ainsi appelés dans le jargon du l'Homme du métier, qui sont disposés chacun en parallèle d'un conducteur de phase 5. Tous les conducteurs de neutre N sont raccordés à un même conducteur de neutre qui provient de la source S de production du courant électrique.

Une telle architecture de réseau triphasé de distribution de courant électrique est bien connue, de sorte qu'il n'est pas nécessaire de la décrire plus en détail ici.

Le réseau 100 est dit communiquant lorsque des unités de communication par CPL sont connectées à certains des conducteurs 5. D'une façon qui est encore connue, chacune de ces unités de communication, notées C, est munie d'un modem M qui constitue l'interface entre un module informatique de cette unité de communication et le réseau 100. Au sein de chaque unité de communication C, le modem M convertit des données numériques à transmettre qui sont produites par le module informatique, en signaux analogiques qui sont transportés par les conducteurs 5 en superposition au courant électrique qui est délivré à des points de consommation de puissance électrique. Inversement, chaque modem M restitue des données numériques qui sont contenues dans des signaux analogiques reçus, et les transmet au module informatique. Chaque unité de communication C est connectée entre un des conducteurs de phase 5 du réseau 100 et un conducteur de neutre N.

Les unités C de communication par CPL peuvent être des compteurs de consommation électrique qui sont disposés à certains au moins des points de consommation de puissance électrique desservis par le réseau 100. Dans la figure 1, de tels compteurs de consommation électrique sont désignés par les références C1, C2 et C3, qui sont connectés aux conducteurs de phase 51, 52 et 53 du réseau 100, respectivement. Pour raison de simplification de formulation et lorsqu'il n'y aura pas de risque de confusion, on pourra assimiler dans la suite une unité de communication C, notamment lorsqu'il s'agit d'un compteur de consommation électrique, et le modem M de cette unité. La référence de l'unité de communication sera alors associée au modem de celle-ci.

La référence 10 indique un concentrateur qui est connecté au réseau 100. De façon connue, un tel concentrateur permet d'interroger les unités de communication C, de traiter et stocker les données et informations qu'il reçoit, et de les transmettre à un système d'information centralisé (non représenté). Lui-même en tant qu'unité de communication, le concentrateur 10 contient aussi un modem, qui est référencé 11 et est connecté à un des conducteurs de phase du réseau 100, indiqué par la référence 50. Evidemment, il est simultanément connecté à un conducteur de neutre N. Pour la suite, on considère que la connexion de ce concentrateur 10 au réseau 100 définit celle des phases qui est prise pour référence, et qui est notée 0°. Autrement dit, le conducteur de phase 50 est le conducteur de phase de référence. Les phases 120° et 240° sont alors fixées par l'ordre chronologique de passage par la valeur nulle sur un front montant, de la tension électrique des conducteurs de phase 5 correspondants. En fait, le concentrateur 10 peut être aussi connecté simultanément à des conducteurs des deux phases 120° et 240°, notamment par des condensateurs, pour améliorer une qualité de transmission des signaux CPL. Mais ces deux connexions supplémentaires du concentrateur 10 n'interviennent pas dans l'identification de la phase de référence, et peuvent être ignorées dans la suite.

Le concentrateur 10 comprend en outre une unité de calcul 12 qui est couplée de façon opérationnelle à des moyens de mémorisation 13. Le modem 11 constitue ainsi l'interface entre le réseau 100 et l'unité de calcul 12, de la façon qui a été décrite plus haut pour le module informatique d'une unité de communication C quelconque.

On suppose pour la suite que le protocole de communication par courant porteur en ligne qui est mis en œuvre dans le réseau 100 satisfait la norme CPL G3. Selon ce protocole, l'émission de trames de transmission, par les modems dans les conducteurs du réseau 100, est asynchrone. Un tel réseau communicant qui est conforme à la norme CPL G3 est le réseau Linky® qui est en cours de déploiement en France par ENEDIS®.

En particulier, le modem M de chaque unité de communication C est capable d'émettre des trames, en insérant dans le champ PDC (voir plus loin) de l'en-tête de chaque trame la valeur instantanée du compteur de phase de ce modem. Il est rappelé que cette valeur instantanée de phase correspond au temps écoulé entre le dernier passage par la valeur nulle, sur front montant, de la tension électrique du conducteur de phase 5 auquel ce modem est connecté, et l'instant d'émission de la trame. La valeur de phase qui est ainsi inscrite dans une trame est donc une indication de la valeur instantanée, à l'émission de la trame, de la phase de la tension électrique du conducteur 5 auquel est connecté le modem M émetteur. La trame est injectée dans le réseau 100 par le modem M émetteur de celle-ci, à partir du conducteur de phase 5 auquel ce modem est connecté.

En particulier, afin d'initialiser sa table des voisins lorsqu'il est nouvellement associé au réseau CPL, chaque modem M émet une requête de balise dans le réseau 100, à partir du connecteur de phase 5 auquel il est connecté. Alors ceux des autres modems M du réseau 100 qui reçoivent cette requête y répondent en émettant chacun une trame de balise dont le champ PDC est utilisé comme décrit ci-dessus.

En référence à la figure 1, et pour illustrer l'invention, on suppose que des trames peuvent être transmises avec des conditions de réception qui sont suffisamment correctes, entre le compteur de consommation électrique C1 et le concentrateur 10. Dans le jargon de l'Homme du métier, le compteur de consommation électrique C1 et le concentrateur 10 sont dits être en visibilité l'un de l'autre, ou être voisins l'un de l'autre dans un sens de communication directe entre eux, mais sans connotation spatiale.

De même, les situations suivantes de visibilité sont aussi supposées pour la suite de la description :

le concentrateur 10 et le compteur de consommation électrique C2 en visibilité l'un avec l'autre,

les compteurs de consommation électrique C1 et C2 en visibilité l'un avec l'autre,

les compteurs de consommation électrique C1 et C3 en visibilité l'un avec l'autre, et

les compteurs de consommation électrique C2 et C3 en visibilité l'un avec l'autre,

mais le concentrateur 10 et le compteur de consommation électrique C3 sont supposés ne pas être en visibilité l'un pour l'autre.

Chaque trame qui est émise par l'un des modems M ou 11 comporte notamment les deux champs suivants dans son en-tête, conformément au protocole CPL G3 :

- un champ désigné par MAC, qui contient une adresse du modem émetteur de la trame ; et

- un champ désigné par PDC, dans lequel le modem émetteur de la trame inscrit la valeur instantanée de son compteur de phase, sous la forme d'un nombre à 8 bits, de 0 à 255, comme indiqué dans la partie introductive de la présente description.

Par exemple, lorsque le modem C1 reçoit des trames, il lit dans chacune d'elles la valeur qui est inscrite dans son champ PDC. La valeur du champ PDC qui a été lue dans chaque trame est alors soustraite de la valeur du compteur de phase du modem C1, qui est lue à l'instant de réception de cette trame par le modem C1. Le résultat de la soustraction correspond au déphasage qui existe entre la tension électrique du conducteur de phase 51 auquel est connecté le modem C1 et celle du conducteur de phase auquel est connecté le modem émetteur de la trame considérée. Eventuellement, ce résultat peut être corrigé d'une contribution qui correspond aux durées de traitement de la trame dans le modem émetteur pour son émission et dans le modem C1 pour la réception et la lecture de cette trame. Une telle correction est omise dans la suite par souci de clarté. Le déphasage qui est ainsi calculé est mémorisé au sein du modem C1 en liaison avec l'adresse du modem émetteur de la trame, telle que lue dans le champ MAC de cette trame.

Plus précisément, la valeur de déphasage suivante est calculée par le modem C1 pour le conducteur 52 auquel est connecté le modem C2 (voir la figure 1) :

$$\Delta\varphi_{1\text{-}2} = (V_1 - V_2)\cdot 360/256$$

où $V_2$ est la valeur du champ PDC de la trame émise par le modem C2, $V_1$ est la valeur instantanée du compteur de phase du modem C1 à l'instant de réception par celui-ci de la trame qui a été émise par le modem C2, et 360/256 est un facteur de conversion entre angles de phase exprimés en degrés et valeurs de compteur de phase à 8 bits.

A partir de toutes les trames qu'il a reçues, ou d'une partie de certaines d'entre elles, le modem C1 construit une table de ses voisins, dite «table des voisins». Une première colonne de cette table contient les adresses des modems émetteurs des trames reçues, et une seconde colonne contient les déphasages calculés de la façon précédente, en correspondance par ligne de la table avec l'adresse du modem émetteur concerné.

De la même façon, le modem C2 construit sa propre table des voisins, et le modem C3 construit encore une autre table des voisins. De même aussi, le modem 11 du concentrateur 10 construit aussi sa propre table des voisins.

La table des voisins du modem C1 contient notamment le déphasage $\Delta\varphi_{1\text{-}2}$ introduit ci-dessus, et la table des voisins du modem C2 contient notamment le déphasage $\Delta\varphi_{2\text{-}1}$. Le déphasage $\Delta\varphi_{2\text{-}1}$ a été calculé de la même façon que le déphasage $\Delta\varphi_{1\text{-}2}$, mais par le modem C2 à partir d'une trame émise par le modem C1. Par conséquent, en l'absence d'erreur de mesure ou de dysfonctionnement, les deux déphasages $\Delta\varphi_{1\text{-}2}$ et $\Delta\varphi_{2\text{-}1}$ sont en principe opposés, modulo 360. Il en est de même pour le déphasage $\Delta\varphi_{2\text{-}3}$ qui est calculé par le modem C2 pour le conducteur 53 auquel est connecté le modem C3, et pour le déphasage $\Delta\varphi_{3\text{-}2}$ qui est calculé par le modem C3 pour le conducteur 52 auquel est connecté le modem C2 : ils sont opposés en principe.

Enfin, étant donné que le concentrateur 10 est en visibilité pour le modem C1, la ligne correspondante de la matrice des voisins du modem C1 contient l'adresse du modem 11 et le déphasage suivant :

$$\Delta\varphi_{1\text{-}10} = (V_1' \text{ - } V_{10})\cdot 360/256$$

où $V_{10}$ est la valeur du champ PDC de la trame émise par le modem 11, et $V_1'$ est la valeur instantanée du compteur de phase du modem C1 à l'instant de réception par celui-ci de la trame qui a été émise par le modem 11. Etant donné que le conducteur de phase 50 auquel est connecté le modem 11 est le conducteur de phase de référence, sa phase est 0° par convention. Alors, la valeur de déphasage $\Delta\varphi_{1\text{-}10}$ est en principe la phase du conducteur 51 auquel est connecté le modem C1, notée $\varphi_1$, modulo 360.

Les tables de voisins sont alors transmises par chaque modem au concentrateur 10. Celui-ci les compile sous la forme d'une matrice d'adjacence qui est construite de la façon maintenant décrite. La direction verticale de la matrice d'adjacence regroupe les adresses des modems M du réseau 100 considérés chacun en tant que source d'une des tables de voisins reçues, et la direction horizontale regroupe les adresses des modems M considérés chacun en tant qu'émetteur de trames. L'unité de calcul 12 recopie alors dans la matrice d'adjacence chaque déphasage qui est lu dans l'une des tables de voisins reçues, à l'intersection de la ligne et de la colonne correspondantes. La matrice d'adjacence est donc remplie par paires de modems selon les adresses de ceux des modems du réseau 100 qui sont en visibilité l'un par rapport à l'autre dans une même paire. Elle est vide à chaque intersection d'une ligne et d'une colonne qui ne correspondent pas à des modems qui sont en visibilité l'un pour l'autre.

Par principe, la matrice d'adjacence devrait être antisymétrique, c'est-à-dire que la valeur de déphasage qui est située à l'intersection de la ligne d'adresse de modem ADDi et de la colonne d'adresse de modem ADDj, devrait être opposée, modulo 360, à la valeur de déphasage qui est située à l'intersection de la ligne d'adresse de modem ADDj et de la colonne d'adresse de modem ADDi. Des écarts par rapport à ce principe d'antisymétrie peuvent avoir des causes multiples, notamment les erreurs de mesure et les dysfonctionnements évoqués plus haut. Un test de cohérence des valeurs de déphasage reçues, qui est optionnel, peut aboutir à supprimer celles des valeurs de déphasage qui violent l'antisymétrie de la matrice d'adjacence. Dans ce cas, seules les valeurs de déphasage qui subsistent dans la matrice d'adjacence après un tel test de cohérence sont disponibles pour être utilisées dans le procédé de l'invention. Le test de cohérence peut être effectué par l'unité de calcul 12.

Un conducteur de phase 5 du réseau 100 dont la phase est recherchée a été appelé conducteur cible dans la partie générale de la présente description. Pour déterminer la phase d'un conducteur cible auquel un modem identifié est connecté, l'unité de calcul 12 va construire des listes ordonnées de conducteurs de phase, appelées suites, pour chacune desquelles deux conducteurs de phase qui sont successifs dans cette suite sont reliés par une valeur de déphasage qui est contenue dans la matrice d'adjacence, via les adresses des modems qui sont connectés un-à-un aux conducteurs de la suite. Chaque suite commence par le conducteur 50 du concentrateur 10, termine par le conducteur cible, et comprend un nombre variable de conducteurs intermédiaires. La longueur de chaque suite est définie comme le nombre de conducteurs de celle-ci. Pour un conducteur cible identifié, l'unité de calcul 12 sélectionne des suites qui possèdent des longueurs minimales, tout en étant différentes. Plusieurs méthodes peuvent être utilisées pour construire de telles suites, qui sont connues de l'Homme du métier. En particulier, des méthodes basées sur l'algorithme de Yen, ou l'algorithme de Dijkstra, ou sur une combinaison de ces deux algorithmes, peuvent être utilisées. De telles méthodes de calcul de chemins les plus courts sont supposées connues, et donc n'ont pas besoin d'être décrites à nouveau ici. En particulier, une fois qu'une première suite la plus courte a été déterminée sur la base du contenu de la matrice d'adjacence entre le conducteur 50 et le conducteur cible identifié, des suites supplémentaires, plus courtes après la première suite déterminée, peuvent être déterminées à leur tour en masquant dans la matrice d'adjacence, un déphasage qui est relatif à un des couples de conducteurs successifs présent dans la première suite la plus courte. Ainsi, pour les conditions de visibilité entre modems du réseau 100 qui ont été indiquées plus haut et à titre d'illustration, les suites suivantes sont construites par l'unité de calcul 12 pour le conducteur cible 53 :

Suite 1 : conducteur 50 avec adresse du concentrateur 10 > conducteur 51 avec adresse du modem C1 > conducteur 53 avec adresse du modem C3

Suite 2 : conducteur 50 avec adresse du concentrateur 10 > conducteur 52 avec adresse du modem C2 > conducteur 53 avec adresse du modem C3

Suite 3 : conducteur 50 avec adresse du concentrateur 10 > conducteur 51 avec adresse du modem C1 > conducteur 52 avec adresse du modem C2 > conducteur 53 avec adresse du modem C3

Evidemment, pour un réseau 100 réel, la longueur de chaque suite construite peut être beaucoup plus grande, et le nombre des suites qui sont construites pour un même conducteur cible peut être très supérieur à 3. Un nombre de suites calculées pour un même conducteur cible, qui est inférieur à 250 permet de limiter la quantité des calculs effectués par l'unité 12.

Pour chaque suite qui relie le conducteur 50 à un conducteur cible du réseau 100, on calcule une somme des déphasages associés à tous les couples distincts de conducteurs successifs qui apparaissent dans cette suite. Les déphasages utilisés sont lus dans la matrice d'adjacence, en cherchant l'adresse du modem qui est connecté au premier conducteur de chaque couple selon la direction verticale de la matrice, et l'adresse du modem qui est connecté au second conducteur de chaque couple selon la direction horizontale de la matrice. Chaque résultat d'addition qui est ainsi obtenu est ensuite ramené à une valeur comprise entre 0°, valeur incluse, et 360°, valeur exclue, par congruence modulo 360. Il peut être aussi ramené à celles des valeurs de phase du réseau 100 qui est la plus proche de ce résultat d'addition, puisque seules les phases du réseau 100 devraient pouvoir être obtenue en tant que résultats d'addition, en principe. L'Homme du métier comprendra aussi que, pour un réseau 100 à nombre impair de phases, un résultat d'addition qui correspond à la valeur supplémentaire par rapport à 180° d'une des phases de ce réseau, révèle une inversion de polarité. Le résultat d'addition doit alors être remplacé par sa valeur supplémentaire.

Séparément pour chaque conducteur cible, on établit ensuite une distribution statistique qui associe à chaque valeur de résultat d'addition la fréquence d'apparition de cette valeur qui apparaît en considérant toutes les suites construites pour ce conducteur cible. La valeur la plus élevée de fréquence d'apparition qui apparaît ainsi pour le conducteur cible considéré, est relevée. Alors, si cette valeur la plus élevée de fréquence d'apparition est inférieure à un seuil de fiabilité, la phase du conducteur cible considéré est déclarée indéterminée. A l'inverse, si la valeur la plus élevée de fréquence d'apparition est supérieure ou égale au seuil de fiabilité, alors la valeur de résultat d'addition qui correspond à cette valeur la plus élevée de fréquence d'apparition est déclarée comme phase qui est déterminée pour le conducteur cible considéré.

Par exemple, le seuil de fiabilité peut être pris égal à 0,85. Des essais dans le réseau triphasé 100 d'ENEDIS® ont montré que cette valeur du seuil de fiabilité permettait d'obtenir un taux de conducteurs bien classés de 99,12%, et un taux de 99,08% pour les conducteurs dont la phase déterminable a été déterminée avec un résultat juste. On entend par conducteur dont la phase est déterminable un conducteur de phase dont la phase peut être vérifiée avec certitude, notamment par au moins une mesure électrique qui est effectuée directement sur ce conducteur. Par opposition, un conducteur dont la phase n'est pas déterminable peut être affecté par un défaut de raccordement qui provoque des fluctuations du déphasage de sa tension électrique par rapport à celle du conducteur de phase de référence. Le taux des conducteurs bien classés regroupe les conducteurs dont la phase déterminable a été déterminée avec un résultat juste, et les conducteurs dont la phase n'est pas déterminable et a été déclarée indéterminée à l'issue du procédé de l'invention. Pour ces essais, 210 suites ont été construites pour chaque conducteur cible.

Un paramétrage préférentiel du procédé de l'invention a été identifié pour un seuil de fiabilité qui est égal à 0,80 et pour 5 suites qui sont construites pour chaque conducteur cible. Le taux des conducteurs bien classés est alors égal à 99,1% alors que la durée de calcul qui est nécessaire pour chaque conducteur cible est courte. Ce paramétrage correspond à un bon compromis entre une valeur élevée pour le taux des conducteurs bien classés et une quantité de calcul qui est réduite. Le taux des conducteurs dont la phase a été déterminée avec un résultat juste parmi les conducteurs cibles à phase déterminable est alors de 99,4%.

Possiblement, le seuil de fiabilité à appliquer à la distribution statistique des résultats d'addition peut varier en fonction du nombre de suites qui ont été construites pour le conducteur cible considéré. Une telle optimisation est à la portée de l'Homme du métier des statistiques. En particulier, une variation croissante du seuil de fiabilité en fonction du nombre de suites construites peut être mise en œuvre préférentiellement.

**Revendications**

1.  Procédé pour déterminer une phase d'un conducteur de phase (5) appartenant à un réseau (100) polyphasé de distribution de courant électrique, notamment un réseau triphasé, dans lequel la phase d'un conducteur de phase quelconque du réseau détermine un déphasage de tension électrique qui existe entre ledit conducteur et un conducteur de phase de référence (50) du réseau,

    le réseau (100) comportant des modems (M) qui sont connectés chacun à un des conducteurs de phase (5) dudit réseau, et qui sont adaptés pour communiquer selon un protocole de courant porteur en ligne, ou CPL, l'un des modems (11) étant connecté au conducteur de phase de référence (50),

le procédé **caractérisé en ce qu'**il comprend la séquence des étapes suivantes, exécutée pour un des conducteurs de phase du réseau, dit conducteur cible, qui est identifié et dont la phase est à déterminer :

/1/ construire plusieurs suites de conducteurs de phase (5) du réseau (100), différentes entre elles et commençant chacune par le conducteur de phase de référence (50), terminant chacune par le conducteur cible, et contenant chacune une sélection ordonnée d'un ou plusieurs conducteurs de phase du réseau, qui sont intermédiaires entre le conducteur de phase de référence et le conducteur cible dans chaque suite, et pour lesquels un déphasage de tension électrique qui existe entre deux conducteurs qui sont successifs dans une des suites a été obtenu par un modem (M) qui est connecté à l'un desdits deux conducteurs, pour tous les couples de conducteurs successifs de chaque suite ;

/2/ pour chaque suite construite à l'étape /1/, calculer un résultat d'addition comme une somme des déphasages de tous les couples de conducteurs (5) successifs de ladite suite ;

/3/ en considérant que les résultats d'addition calculés à l'étape /2/ forment une distribution statistique, et compte tenu d'une congruence entre des valeurs différentes qui représentent un même déphasage, déterminer celui desdits résultats d'addition qui possède une fréquence d'apparition la plus élevée ; et

/4/ déclarer le résultat d'addition qui possède la fréquence d'apparition la plus élevée comme phase du conducteur cible si ladite fréquence d'apparition la plus élevée est supérieure ou égale à un seuil de fiabilité prédéfini, sinon déclarer la phase du conducteur cible comme étant indéterminée si ladite fréquence d'apparition la plus élevée est inférieure au seuil de fiabilité.

2. Procédé selon la revendication 1, suivant lequel le seuil de fiabilité utilisé à l'étape /4/ est compris entre 0,7 et 0,9, et le nombre de suites qui sont construites à l'étape /1/ pour chaque conducteur cible est compris entre 3 et 15.

3. Procédé selon la revendication 1 ou 2, suivant lequel les suites construites à l'étape /1/ pour le même conducteur cible comprennent au moins une suite qui est la plus courte parmi lesdites suites et des suites supplémentaires, les suites supplémentaires étant sélectionnées de façon à minimiser une augmentation de longueur de chaque suite supplémentaire par rapport à la au moins une suite qui est la plus courte, la longueur de chaque suite étant un nombre des conducteurs (5) de ladite suite.

4. Procédé selon l'une quelconque des revendications précédentes, suivant lequel, pour au moins un des couples de conducteurs (5) successifs d'une des suites, deux valeurs du déphasage de tension électrique qui existe entre les deux conducteurs du couple sont collectées séparément, l'une desdites deux valeurs du déphasage à partir d'un modem qui est connecté à l'un desdits deux conducteurs, et l'autre desdites deux valeurs du déphasage à partir d'un autre modem qui est connecté à l'autre desdits deux conducteurs, et ledit couple de conducteurs successifs n'est utilisé dans l'une des suites qui est construite à l'étape /1/ que si lesdites deux valeurs du déphasage sont opposées.

5. Procédé selon l'une quelconque des revendications précédentes, suivant lequel un concentrateur (10) du réseau (100) est connecté au conducteur de phase de référence (50).

6. Procédé selon la revendication 5, mis en œuvre par le concentrateur (10), et suivant lequel chaque déphasage de tension électrique qui existe entre deux conducteurs (5) successifs d'une des suites construites à l'étape /1/ est transmis au concentrateur par un modem (M) qui est connecté à l'un desdits deux conducteurs.

7. Procédé selon l'une quelconque des revendications précédentes, suivant lequel chaque déphasage de tension électrique qui existe entre deux conducteurs (5) qui sont successifs dans une des suites, a été obtenu par un modem (M) qui est connecté à l'un desdits deux conducteurs, dit modem récepteur, en recevant une trame qui a été émise par un autre modem connecté à l'autre desdits deux conducteurs, dit modem émetteur, et en comparant une indication de valeur instantanée de phase de tension électrique qui a été inscrite dans la trame par le modem émetteur à un instant d'émission de ladite trame, avec une valeur instantanée d'un compteur de phase du modem récepteur, telle qu'existant à un instant de réception de ladite trame par le modem récepteur.

8. Procédé selon l'une quelconque des revendications précédentes, suivant lequel les phases de plusieurs conducteurs de phase (5) du réseau (100), telles que déclarées chacune lors d'une exécution de l'étape /4/, lorsque lesdites phases sont différentes, sont utilisées pour équilibrer entre lesdits plusieurs conducteurs de phase une puissance électrique qui est fournie par le réseau.

9. Concentrateur (10) pour réseau (100) polyphasé de distribution de courant électrique, lorsque ledit réseau comporte des modems (M) qui sont connectés chacun à un des conducteurs de phase (5) dudit réseau, et qui sont adaptés pour communiquer selon un protocole de courant porteur en ligne, ou CPL,

le concentrateur (10) étant adapté pour obtenir des déphasages qui existent entre des tensions électriques respectives de conducteurs de phase (5) du réseau (100) associés en couples de conducteurs, avec une valeur de déphasage pour chaque couple de conducteurs, et le concentrateur (10) comprenant un modem (11) dédié, une unité de calcul (12) et des moyens de mémorisation (13) agencés pour mettre en œuvre un procédé qui est conforme à l'une quelconque des revendications 1 à 8.

10. Logiciel pour concentrateur, en tant que produit programme d'ordinateur, comprenant des codes de programmation qui sont adaptés de sorte que lorsque ledit logiciel est mis en œuvre dans un concentrateur (10) d'un réseau (100) polyphasé de distribution de courant électrique, le réseau comportant des modems (M) connectés chacun à un des conducteurs de phase (5) du réseau, et les modems étant adaptés pour communiquer selon un protocole de courant porteur en ligne, ou CPL, ledit concentrateur exécute un procédé qui est conforme à l'une quelconque des revendications 1 à 8.

**Patentansprüche**

1. Verfahren zur Bestimmung einer Phase eines Phasenleiters (5), der zu einem mehrphasigen Netz (100) zur Verteilung von elektrischem Strom, insbesondere einem Dreiphasennetz, gehört, wobei die Phase eines beliebigen Phasenleiters des Netzes eine elektrische Spannungsphasenverschiebung bestimmt, die zwischen dem Leiter und einem Referenzphasenleiter (50) des Netzes besteht, wobei das Netz (100) Modems (M) umfasst, die jeweils mit einem der Phasenleiter (5) des Netzes verbunden sind und die zur Kommunikation gemäß einem Powerline-Protokoll (PLC) geeignet sind, wobei eines der Modems (11) mit dem Referenzphasenleiter (50) verbunden ist, wobei das Verfahren **dadurch gekennzeichnet ist, dass** es die folgende Abfolge von Schritten umfasst, die für einen der Phasenleiter des Netzes, den sogenannten Zielleiter, ausgeführt wird, der identifiziert wird und dessen Phase bestimmt werden soll:

/1/ Konstruktion mehrerer Folgen von Phasenleitern (5) des Netzes (100), die sich voneinander unterscheiden und jeweils mit dem Referenzphasenleiter (50) beginnen, jeweils mit dem Zielleiter enden und jeweils eine geordnete Auswahl eines oder mehrerer Phasenleiter des Netzes enthalten, die in jeder Folge zwischen dem Referenzphasenleiter und dem Zielleiter liegen und für die eine elektrische Spannungsphasenverschiebung, die zwischen zwei Leitern besteht, die in einer der Folgen aufeinander folgen, durch ein Modem (M) erhalten wurde, das mit einem der beiden Leiter verbunden ist, für alle Paare aufeinander folgender Leiter jeder Folge ;
/2/ für jede in Schritt /1/ konstruierte Folge Berechnung eines Additionsergebnisses als Summe der Phasenverschiebungen aller Paare von erfolgreichen Leitern (5) der Folge;
/3/ unter der Annahme, dass die in Schritt /2/ berechneten Additionsergebnisse eine statistische Verteilung darstellen, und unter Berücksichtigung einer Kongruenz zwischen verschiedenen Werten, die dieselbe Phasenverschiebung darstellen, Bestimmung desjenigen Additionsergebnisse, das die höchste Auftrittshäufigkeit aufweist; und
/4/ Deklaration des Additionsergebnisses mit der höchsten Auftrittsfrequenz zur Phase des Zielleiters, wenn die höchste Auftrittsfrequenz größer oder gleich einem vordefinierten Zuverlässigkeitsschwellenwert ist, und andernfalls Deklaration der Phase des Zielleiters als unbestimmt, wenn die höchste Auftrittsfrequenz kleiner als der Zuverlässigkeitsschwellenwert ist.

2. Verfahren nach Anspruch 1, wobei der in Schritt /4/ verwendete Zuverlässigkeitsschwellenwert zwischen 0,7 und 0,9 liegt und die Anzahl der Folgen, die in Schritt /1/ für jeden Zielleiter konstruiert werden, zwischen 3 und 15 liegt.

3. Verfahren nach Anspruch 1 oder 2, wobei die in Schritt /1/ für denselben Zielleiter konstruierten Folgen wenigstens eine Folge umfassen, die die kürzeste der Folgen ist, und zusätzliche Folgen umfassen, wobei die zusätzlichen Folgen derart ausgewählt werden, dass eine Zunahme der Länge jeder zusätzlichen Folge im Vergleich zu der wenigstens einen Folge, die die kürzeste ist, minimiert wird, wobei die Länge jeder Folge eine Anzahl der Leiter (5) der Folge ist.

4. Verfahren nach einem der vorhergehenden Ansprüche, wobei für wenigstens eines der Paare aufeinanderfolgender Leiter (5) einer der Folgen zwei Werte der Phasenverschiebung der elektrischen Spannung, die zwischen den beiden Leitern des Paares besteht, getrennt erfasst werden, wobei einer der beiden Werte der Phasenverschiebung von einem Modem stammt, das mit einem der beiden Leiter verbunden ist, und der andere der beiden Werte der Phasenverschiebung von einem anderen Modem stammt, das mit dem anderen der beiden Leiter verbunden ist, und wobei das Paar aufeinanderfolgender Leiter nur dann in einer der in Schritt /1/ konstruierten Folgen verwendet wird, wenn die beiden Werte der Phasenverschiebung entgegengesetzt sind.

5. Verfahren nach einem der vorhergehenden Ansprüche, wobei ein Konzentrator (10) des Netzes (100) mit dem Referenzphasenleiter (50) verbunden wird.

6. Verfahren nach Anspruch 5, das durch den Konzentrator (10) implementiert wird und wobei jede Phasenverschiebung der elektrischen Spannung, die zwischen zwei aufeinander folgenden Leitern (5) einer der in Schritt /1/ konstruierten Folgen besteht, durch ein Modem (M), das mit einem der beiden Leiter verbunden ist, an den Konzentrator übertragen wird.

7. Verfahren nach einem der vorhergehenden Ansprüche, wobei jede elektrische Spannungsphasenverschiebung, die zwischen zwei Leitern (5) besteht, die in einer der Folgen aufeinander folgen, von einem Modem (M) erhalten wurde, das mit einem der beiden Leiter verbunden ist, dem sogenannten Empfängermodem, indem ein Rahmen empfangen wurde, der von einem anderen Modem gesendet wurde, das mit dem anderen der beiden Leiter verbunden ist, dem sogenannten Sendermodem, und indem eine Anzeige eines momentanen Wertes einer Phase einer elektrischen Spannung, die von dem Empfängermodem zu einem Zeitpunkt der Übertragung des Rahmens in den Rahmen geschrieben wurde, mit einem momentanen Wert eines Phasenzählers des Empfängermodems verglichen wird, wie er zu einem Zeitpunkt des Empfangs des Rahmens durch das Empfängermodem besteht.

8. Verfahren nach einem der vorhergehenden Ansprüche, wobei die Phasen mehrerer Phasenleiter (5) des Netzes (100), wie sie jeweils bei der Durchführung von Schritt /4/ gemeldet werden, wenn die Phasen unterschiedlich sind, verwendet werden, um zwischen den mehreren Phasenleitern eine elektrische Leistung auszugleichen, die von dem Netz geliefert wird.

9. Konzentrator (10) für ein mehrphasiges Stromverteilungsnetz (100), wenn das Netz Modems (M) umfasst, die jeweils mit einem der Phasenleiter (5) des Netzes verbunden sind und die zur Kommunikation gemäß einem Powerline-Protokoll (PLC) geeignet sind,

wobei der Konzentrator (10) dazu ausgelegt ist, Phasenverschiebungen zu erhalten, die zwischen jeweiligen elektrischen Spannungen von Phasenleitern (5) des Netzes (100) bestehen, die zu Leiterpaaren verbunden sind, mit einem Phasenverschiebungswert für jedes Leiterpaar, und

wobei der Konzentrator (10) ein eigenes Modem (11), eine Recheneinheit (12) und Speichermittel (13) umfasst, die dazu angeordnet sind, einen Prozess zu implementieren, der einem der Ansprüche 1 bis 8 entspricht.

10. Konzentrator-Software als Computerprogrammprodukt, welches Programmiercodes umfasst, die derart ausgebildet sind, dass, wenn die Software in einem Konzentrator (10) eines mehrphasigen Stromverteilungsnetzes (100) implementiert ist, wobei das Netz Modems (M) aufweist, die jeweils mit einem der Phasenleiter (5) des Netzes verbunden sind, und die Modems so ausgebildet sind, dass sie gemäß einem Powerline-Protokoll (PLC) kommunizieren, der Konzentrator einen Prozess ausführt, der einem der Ansprüche 1 bis 8 entspricht.

## Claims

1. A method for determining a phase of a phase conductor (5) belonging to a polyphase electric current distribution network (100), in particular a three-phase network, wherein the phase of any phase conductor of the network determines an electrical voltage phase shift which exists between said conductor and a reference phase conductor (50) of the network,

the network (100) including modems (M) which are each connected to one of the phase conductors (5) of said network, and which are adapted to communicate according to a power line carrier, or PLC, protocol, one of the modems (11) being connected to the reference phase conductor (50),
the method **characterised in that** it comprises the sequence of the following steps, executed for one of the phase conductors of the network, called target conductor, which is identified and whose phase is to be determined:

/1/ constructing several sequences of phase conductors (5) of the network (100), different from each other and each starting with the reference phase conductor (50), each ending with the target conductor, and each containing an ordered selection of one or more network phase conductors, which are intermediate between the reference phase conductor and the target conductor in each sequence, and for which an electrical voltage phase shift which exists between two conductors which are successive in one of the sequences has been obtained by a modem (M) which is connected to one of said two conductors, for all pairs of successive conductors of each sequence;

/2/ for each sequence constructed in step /1/, calculating an addition result as a sum of the phase shifts of all pairs of successive conductors (5) of said sequence;

/3/ considering that the addition results calculated in step /2/ form a statistical distribution, and taking into account a congruence between different values which represent one same phase shift, determining which of said addition results has a highest frequency of occurrence; and

/4/ declaring the addition result which has the highest frequency of occurrence as the phase of the target conductor if said highest frequency of occurrence is greater than or equal to a predefined reliability threshold, otherwise declaring the phase of the target conductor as being indeterminate if said highest frequency of occurrence is less than the reliability threshold.

2. The method according to claim 1, wherein the reliability threshold used in step /4/ is comprised between 0.7 and 0.9, and the number of sequences which are constructed in step /1/ for each target conductor is comprised between 3 and 15.

3. The method according to claim 1 or 2, wherein the sequences constructed in step /1/ for the same target conductor comprise at least one sequence which is the shortest among said sequences and additional sequences, the additional sequences being selected so as to minimise an increase in length of each additional sequence relative to the at least one sequence which is the shortest, the length of each sequence being a number of the conductors (5) of said sequence.

4. The method according to any one of the preceding claims, wherein, for at least one of the pairs of successive conductors (5) of one of the sequences, two values of the electrical voltage phase shift which exists between the two conductors of the pair are collected separately, one of said two values of the phase shift from a modem which is connected to one of said two conductors, and the other of said two phase shift values from another modem which is connected to the other of said two conductors, and said pair of successive conductors is used in one of the sequences which is constructed in step /1/ only if said two values of the phase shift are opposite.

5. The method according to any one of the preceding claims, wherein a concentrator (10) of the network (100) is connected to the reference phase conductor (50).

6. The method according to claim 5, implemented by the concentrator (10), and wherein each electrical voltage phase shift which exists between two successive conductors (5) of one of the sequences constructed in step /1/ is transmitted to the concentrator by a modem (M) which is connected to one of said two conductors.

7. The method according to any one of the preceding claims, wherein each electrical voltage phase shift which exists between two conductors (5) which are successive in one of the sequences, has been obtained by a modem (M) which is connected to one of said two conductors, called receiver modem, by receiving a frame which has been emitted by another modem connected to the other of said two conductors, called transmitter modem, and by comparing an indication of instantaneous value of the electrical voltage phase which has been entered into the frame by the transmitter modem at a time of emission of said frame, with an instantaneous value of a phase counter of the receiver modem, such as existing at a time of reception of said frame by the receiver modem.

8. The method according to any one of the preceding claims, wherein the phases of several phase conductors (5) of the network (100), as each declared during an execution of the step /4/, when said phases are different, are used to balance, between said several phase conductors, an electric power which is provided by the network.

9. A concentrator (10) for a polyphase electric current distribution network (100), when said network includes modems (M) which are each connected to one of the phase conductors (5) of said network, and which are adapted to communicate according to a power line carrier, or PLC, protocol,

the concentrator (10) being adapted to obtain phase shifts which exist between respective electrical voltages of phase conductors (5) of the network (100) which are associated in pairs of conductors, with a phase shift value for each pair of conductors, and

the concentrator (10) comprising a dedicated modem (11), a calculation unit (12) and storage means (13) arranged to implement a method which is in accordance with any one of claims 1 to 8.

10. A concentrator software, as a computer program product, comprising programming codes which are adapted such that when said software is implemented in a concentrator (10) of a polyphase electric current distribution network (100), the network including modems (M) each connected to one of the phase conductors (5) of the network, and the modems being adapted to communicate according to a power line carrier, or PLC, protocol, said concentrator executes a method which is in accordance with any one of claims 1 to 8.

**FIG. 1**

## RÉFÉRENCES CITÉES DANS LA DESCRIPTION

**Documents brevets cités dans la description**

- WO 2005116668 A1
- EP 2685267 A1
- US 20150091545 A1